# EUROPEAN PATENT APPLICATION

(11) **EP 4 769 090 A1**
(43) Date of publication of application: **01.07.2026**
(21) Application number: 25224551.9
(22) Date of filing: 17.12.2025
(51) Int. Cl.: G06F 3/041

(54) **DISPLAY DEVICE**

(30) Priority: 30.12.2024 KR 20240200557
(71) Applicant: LG Display Co., Ltd., Seoul 07336 (KR)
(72) Inventor: LEE, Yong-Ku, Paju-si 10845 (KR); LEE, DaeHeung, Paju-si 10845 (KR); YOON, ARa, Paju-si 10845 (KR); HONG, JinWoo, Paju-si 10845 (KR); OH, SeWan, Paju-si 10845 (KR); LEE, YoungBok, Paju-si 10845 (KR)
(74) Representative: Poll, Christopher

(57) **Abstract**

A display device is provided showing, relative to conventional devices, improved performance after thermal degradation. The display device provides a reduced difference between luminance of a degraded device and luminance of a non-degraded device at extreme viewing angles, where this difference cannot be fully addressed by front compensation. Improvement over display devices having subpixels disposed in a regular two dimensional array is accomplished by offsetting a portion of subpixel light-emitting areas along a critical dimension within the plane of a flat screen relative to corresponding subpixel lenses, a design that compensates for shrinkage in subpixel light-emitting areas in degraded displays.

## Description

### CROSS REFERENCE TO RELATED APPLICATION

This application claims priority from and the benefit of Korean Patent Application No. 10-2024-0200557, filed on December 30, 2024, which is hereby incorporated by reference for all purposes as if fully set forth herein.

### FIELD

Embodiments of the disclosure relate generally to a display device, and more particularly, to a display device providing a reduced difference between luminance of a degraded device and luminance of a non-degraded device at extreme viewing angles where this difference cannot be fully addressed by front compensation.

### DISCUSSION OF THE BACKGROUND

With the advancement of technologies in modern society, display devices are being used in various ways to provide information to users. The display devices may be included in electronic display boards, which simply transfer visual information in one direction, and they also may be included in various high-technology electronic devices that identify user inputs and provide information in response to identified inputs.

For example, the display device may be included in a vehicle and may provide various types of information to a driver and a passenger in the vehicle. However, the display device in the vehicle is required to appropriately display content so as not to hinder the operation of the vehicle. For example, the display device needs to restrict a display of content that may decrease the driver's concentration on driving while the vehicle travels.

This means that a narrow angular field of view in a vertical direction is especially important in automotive applications because, if the vertical viewing angle is too large, an image shown by a display device could reflect from the windshield and distract a driver. For this reason, automotive display devices are deliberately made with a limited vertical viewing angle. Additionally, an automotive display device might not always be installed at eye level for the driver, so a vertical viewing angle that is too small would cause difficulty.

Though modern display devices are greatly improved over early ones, they are still subject to degradation due to various factors such as electrical stress on light-emitting compounds, heat effects on materials, humidity (a well-known factor in the degradation of many organic compounds), and sunlight (the ultraviolet light component can break down organic compounds). Manufacturing defects in the panels, heavy use of certain pixels more than others, and the effects of static images displayed for extended periods all can contribute to display device degradation.

Display device degradation tends to manifest in the form of shrinkage of the light-emitting areas of some of the subpixels of the device. The combination of a smaller light-emitting area and a fixed lens geometry and aperture for dispensing light from a subpixel can lead to a reduced viewing angle. This is more noticeable in the vertical dimension of an automotive display device, where the vertical viewing angle is already limited. Thus, maintaining a useful vertical viewing angle range as close as possible to that initially enjoyed is important for convenience and safety. While electronic compensation can be applied to compensate for display degradation, this technique does not replace the lost edge portions of light-emitting areas, so electronic compensation is not effective in restoring initial device function at viewing angle extremes. There is a need in the art for a design solution that will maintain the viewing angle range of a display device despite the subpixel light-emitting area shrinkage caused by degradation factors.

The above information disclosed in this Background section is only for understanding of the background of the concepts disclosed herein, and, therefore, it may contain information that does not constitute prior art.

### SUMMARY

The aforementioned need in the art is addressed by the present disclosure. An object to be achieved by the present disclosure is to provide a display device capable of delivering an image over an entire original viewing angle range as an observer moves in an upward/downward direction relative to a device screen despite degradation of display components.

Another object to be achieved by the present disclosure is to provide a display device capable of inhibiting an image from being reflected by a structure positioned outside the display device. This means that the previously mentioned object must be achieved without expanding the original viewing angle range of the device.

Still another object to be achieved by the present disclosure is to provide a display device capable of reducing a luminance difference between a degraded light-emitting area and a non-degraded light-emitting area, where the luminance difference is more noticeable at extreme viewing angles.

Additional features of the concepts disclosed herein will be set forth in the description which follows, and in part will be apparent from the description, or may be learned by practice of the concepts disclosed herein.

In one aspect, the present disclosure provides a display device having a display that can include a plurality of pixels, each pixel comprising a substrate layer, a plurality of subpixels, each subpixel emitting red, green, or blue light when electrically stimulated, wherein each subpixel comprises a light emitting element, the light emitting element comprising a first electrode layer, a light emitting layer and a second electrode layer, formed sequentially on the substrate, an insulating touch buffer layer formed on the second electrode, a touch electrode formed on the touch buffer layer, and an optical member, peripheral portions of the optical member being formed on the touch electrode, and an insulating bank layer comprising an opening corresponding to each subpixel, wherein a portion of the bank layer corresponding to a peripheral region of each opening in the bank layer is formed on the first electrode of each subpixel, thereby preventing light emission from each said peripheral region of each opening in the bank layer and defining a light emitting area for each light emitting element, wherein the subpixels are grouped into subpixel groups, each subpixel group consisting of three subpixels having a like color emission when electrically stimulated, the subpixels of each subpixel group being located immediately adjacent to another subpixel of that subpixel group, wherein the subpixel groups are arrayed in two dimensions, X and Y, where subpixel groups corresponding to the three emitted colors, red, green and blue, are substantially intermixed in their locations in the array, and where dimensions X, Y and a third Z dimension are mutually perpendicular, wherein a light emitting area for each subpixel, defined as an area traversed by emitted light after passing through the optical member and as projected onto the X-Y plane, is larger than a light emitting area for the corresponding light emitting element but substantially smaller than a projection of a shape of the optical member onto the X-Y plane, wherein, for each subpixel group, a first subpixel has a subpixel light emitting area centrally aligned with the optical member along the Z axis, where a geometric center of the light emitting area coincides with a geometric center of a projection along the Z axis of the shape of the optical member onto the X-Y plane, a second subpixel has a subpixel light emitting area shifted in a first direction along the Y axis in comparison to the first subpixel, and a third subpixel has a subpixel light emitting area shifted in a second, opposite to the first, direction along the Y axis in comparison to the first subpixel, and wherein, for each subpixel, the light emitting area is fully included within the projection along the Z axis of the shape of the optical member onto the X-Y plane.

In some embodiments, the display device can further comprise one or more additional touch electrode(s) formed on the touch buffer layer.

In some embodiments of the display device, the plurality of touch electrodes can be positioned on peripheral parts of the touch buffer layer and can interface with peripheral portions of the optical member.

In some embodiments of the display device, each pixel can comprise a subpixel group emitting red light, a subpixel group emitting green light and a subpixel group emitting blue light.

In some embodiments of the display device, each subpixel light emitting area can be rectangular in shape, the projection of the shape of each optical member onto the X-Y plane can be rectangular in shape, the subpixels can be arrayed with long dimensions adjacent in each subpixel group, and subpixel groups can be arrayed with short dimensions of the subpixels adjacent to short dimensions of a next subpixel group, and a three subpixel by three subpixel two dimensional array of subpixel light emitting areas can be formed for each pixel in the X-Y plane.

In some embodiments, for each pixel, for each subpixel row having a red emitting subpixel, a green emitting subpixel and a blue emitting subpixel, each of the three subpixels can have the same shift of subpixel light emitting area along the Y axis in comparison with the subpixel that is centrally aligned with the optical member along the Z axis.

In some embodiments of the display device, each pixel can include one first subpixel group, three second subpixel groups and three third subpixel groups, wherein each subpixel light emitting area is substantially rectangular in shape, wherein the projection of the shape of each optical member onto the X-Y plane is substantially rectangular in shape, wherein the subpixels are arrayed with long dimensions adjacent in each second or third subpixel group and the subpixels are arrayed with short dimensions adjacent in the first subpixel group, and subpixel groups are arrayed with short dimensions of the subpixels adjacent to short dimensions of subpixels of a next subpixel group for interfaces of a second subpixel group with a third subpixel group, but subpixel groups have long dimensions of the subpixels adjacent to long dimensions of a next subpixel group for interfaces of the first subpixel group with a second subpixel group or a third subpixel group, and wherein an array in which each pixel includes seven subpixel groups is formed in the X-Y plane. In some embodiments, the first subpixel group can be configured to emit a red color, the second subpixel groups can be configured to emit a green color, and the third subpixel groups can be configured to emit a blue color.

In some embodiments of the display device, the second subpixel groups and the third subpixel groups can be arranged alternately along the long dimension of the first subpixel group in the X-Y plane, wherein each row of six second or third subpixel groups arranged with short subpixel dimensions adjacent can have the same shift of subpixel light emitting area along the Y axis in comparison with the subpixel that is centrally aligned with the optical member along the Z axis. In embodiments, the first subpixel group can be configured to emit a red color, the second subpixel groups can be configured to emit a green color and the third subpixel groups can be configured to emit a blue color.

In other embodiments of the display device, the second subpixel groups and the third subpixel groups can be arranged alternately along the long dimension of the first subpixel group in the X-Y plane, wherein each row of six second or third subpixel groups arranged with short dimensions adjacent shows in equal numbers a shift of subpixel light emitting area along the Y axis in comparison with the subpixel that is centrally aligned with the optical member along the Z axis that is null (no shift), in a first direction along the Y axis, and in a second direction along the Y axis. In embodiments, the first color can be red, the second color can be green, and the third color can be blue.

In some embodiments of the display device, the substrate layer, the light emitting layer, the second electrode layer and the touch buffer layer can be continuous across the entire display.

In some embodiments of the display device, a buffer film can be formed on the substrate, a transistor layer can be formed on the buffer film, an overcoating layer can be formed on the transistor layer, and the first electrode can be formed on the overcoating layer, wherein the transistor layer can comprise a gate insulation film formed on the buffer layer, a first interlayer insulation film formed on the gate insulation film, and a lower protective film formed on the first interlayer insulation film, wherein, in a region of each subpixel, a transistor can be formed in the transistor layer corresponding to each first electrode, each transistor comprising a semiconductor layer formed on the buffer film, the gate insulation film formed on the semiconductor layer, a gate electrode formed on the gate insulation film, the first interlayer insulation film formed on the gate electrode, a source electrode formed on the first interlayer insulation film and in electrical contact with the semiconductor layer, a drain electrode formed on the first interlayer insulation film and in electrical contact with the semiconductor layer, the lower protective film formed on the source electrode and the drain electrode, and the overcoating layer formed on the lower protective film, and wherein the first electrode is in electrical contact with either the source electrode or the drain electrode.

In some embodiments, an encapsulation member can be formed on the second electrode, the touch buffer layer can be formed on the encapsulation member, one or more touch bridge electrode(s) can be formed on peripheral regions of the touch buffer layer, a second insulation film can be formed on the touch bridge electrode(s) and on the touch buffer layer, one or more opaque black matrix layer areas can be formed on peripheral portions of the second insulation film, a third interlayer insulation film can be formed on the opaque black matrix layer and on the second insulation film, one or more touch electrodes can be formed on the third interlayer insulation film, the optical member can be formed on the touch electrode(s) and on the third interlayer insulation film, an optical member protection film can be formed on the touch electrode(s) and on the optical member, each touch electrode can penetrate the third interlayer insulation film, the black matrix and the second insulation film to electrically contact a touch bridge electrode, and the encapsulation member can comprise a first encapsulation layer, a second encapsulation layer and a third encapsulation layer, which can be sequentially formed on the second electrode.

In some embodiments of the display device, a perceived dependence of a luminance on a viewing angle can be reduced in comparison with a comparable device for which all subpixel light emitting areas are centrally aligned with the corresponding subpixel optical member along the Z axis.

In some embodiments of the display device, the Y axis can extend along a vertical direction of a display screen.

In some embodiments of the display device, all optical members can be arrayed in rows and columns in the X-Y plane, wherein each optical member can be separated from each neighboring optical member by the same distance.

In some embodiments of the display device, a portion of the bank layer corresponding to a peripheral region of each opening in the bank layer can be formed on the first electrode layer of each subpixel, thereby preventing light emission from each said peripheral region of each opening in the bank layer.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the disclosure and are incorporated in and constitute a part of this specification, illustrate embodiments of the disclosure, and together with the description serve to explain the concepts disclosed herein.
FIG. 1 is an exemplified view of a display device according to an embodiment of the present disclosure.
FIG. 2 is a functional block diagram of the display device according to the embodiment of the present disclosure.
FIG. 3 is an enlarged top plan view of a pixel included in the display device according to an embodiment of the present disclosure.
FIG. 4 is a cross-sectional view illustrating an example taken along line IV-IV' in FIG. 3.
FIG. 5 is a cross-sectional view illustrating an example taken along line V-V' in FIG. 3. Dotted lines indicate shifts in positions of optical members consistent with an embodiment of the present disclosure.
FIG. 6A is a graph illustrating percent luminance difference between degraded and non-degraded samples as a function of viewing angle in a comparative example of the present disclosure. Compensation was done to adjust the luminance difference to zero at zero viewing angle (line of sight along a perpendicular from the device screen).
FIG. 6B is a graph illustrating percent luminance difference between degraded and non-degraded samples as a function of viewing angle for a display device according to an embodiment of the present disclosure. Compensation was done to adjust the luminance difference to zero at zero viewing angle (line of sight along a perpendicular from the device screen).
FIG. 7 is an enlarged top plan view of a pixel included in a display device according to an embodiment of the present disclosure.
FIG. 8 is an enlarged top plan view of a pixel included in a display device according to another embodiment of the present disclosure.
FIG. 9 is an enlarged top plan view of a pixel included in a display device according to yet another embodiment of the present disclosure.

### DETAILED DESCRIPTION

As will be apparent from the description below, the present disclosure allows for less distorted images when a degraded display screen is viewed from a point near an edge of a viewing range that the device had when it was new. Less distorted images are more satisfying for the user, as more vibrant colors, sharper details and generally truer images lead to less eye strain and easier communication. As display devices become more ubiquitous as part of many vehicles, machines and appliances, the viewing experience becomes ever more important.

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods employing one or more of the inventive concepts disclosed herein. It is apparent, however, that various embodiments may be practiced without these specific details or with one or more equivalent arrangements. In other instances, well-known structures and devices are shown in block diagram form in order to avoid unnecessarily obscuring various embodiments. Further, various embodiments may be different, but do not have to be exclusive. For example, specific shapes, configurations, and characteristics of an embodiment may be used or implemented in another embodiment without departing from the inventive concepts.

Unless otherwise specified, the illustrated embodiments are to be understood as providing features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the D1-axis, the D2-axis, and the D3-axis are not limited to three axes of a rectangular coordinate system, such as the x, y, and z - axes, and may be interpreted in a broader sense. For example, the D1-axis, the D2-axis, and the D3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of idealized embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the inventive concepts. Further, the blocks, units, and/or modules of some embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a display device according to exemplary embodiments of the present disclosure will be described in detail with reference to accompanying drawings.

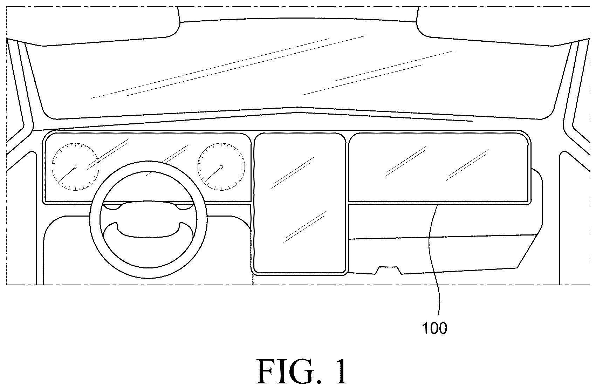

FIG. 1 is an exemplified view of a display device according to an embodiment of the present disclosure.

With reference to FIG. 1, a display device 100 may be disposed on at least a part of a dashboard of a vehicle. The dashboard of the vehicle may include a configuration disposed at a front side of a front seat (e.g., a driver seat or a passenger seat) of the vehicle. For example, the dashboard of the vehicle may be equipped with an input configuration for manipulating various functions (e.g., an air conditioner, an audio system, and a navigation system) in the vehicle.

The display device 100 may be disposed on the dashboard of the vehicle and operate as an input part for manipulating at least some of various functions of the vehicle. The display device 100 may provide various types of information related to the vehicle, e.g., driving information of the vehicle (e.g., a current speed of the vehicle, a remaining fuel amount, and a traveling distance), information on components of the vehicle (e.g., a degree of damage to a vehicle tire), and the like.

The display device 100 may be disposed to traverse the driver seat and the passenger seat disposed as the front seat of the vehicle. Users of the display device 100 may include a driver of the vehicle, and a fellow passenger seated in the passenger seat. Both the driver and the fellow passenger in the vehicle may use the display device 100.

FIG. 1 may illustrate only a part of the display device. The display device 100 illustrated in FIG. 1 may be understood as a display panel among various components included in the display device 100. Specifically, for example, the display device 100 illustrated in FIG. 1 may be envisioned as only a part of a display area and only a part of a non-display area of the display panel.

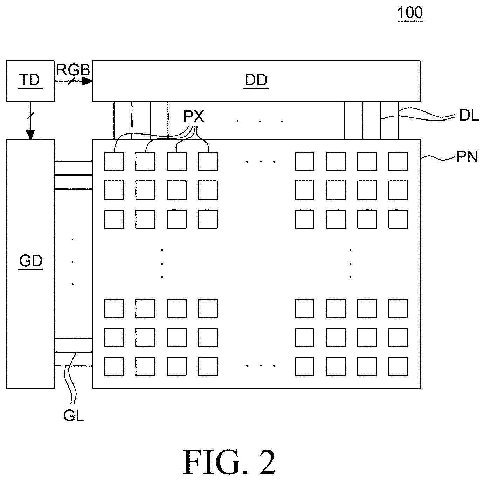

FIG. 2 is a functional block diagram of the display device according to the embodiment of the present disclosure.

Designers of various types of electroluminescent display devices may benefit from the teachings of the present disclosure. An organic light-emitting diode display device, a quantum-dot light-emitting diode display device, or an inorganic light-emitting diode display device may be used as the electroluminescent display device.

With reference to FIG. 2, the display device 100 may include a display panel PN, a data drive circuit DD, a gate drive circuit GD, and a timing controllerTD.

The display panel PN may create an image to be provided to the user. For example, the display panel PN may create and display images, which are to be provided to the user, through a plurality of pixels PX in which pixel circuits are disposed.

The data drive circuit DD, the gate drive circuit GD, and the timing controller TD may provide signals for operating the pixels PX through signal lines. For example, the signal lines for providing the signals for operating the pixels PX may include the plurality of data lines DL and the plurality of gate lines GL.

The plurality of data lines DL may include a plurality of lines arranged in a column direction and connected to the pixels PX disposed in one column direction. The plurality of gate lines GL may include a plurality of lines arranged in a row direction and connected to the pixels PX disposed in one row direction.

In some instances, the display device 100 may further include a power source unit. In this case, the signal for operating the pixel PX may be provided through a power line that connects the power source unit and the display panel PN. According to an embodiment, the power source unit may provide power to the data drive circuit DD and the gate drive circuit GD. The data drive circuit DD and the gate drive circuit GD may operate on the basis of power provided from the power source unit.

For example, the data drive circuit DD may apply data signals to the pixels PX through the plurality of data lines DL, the gate drive circuit GD may apply gate signals to the pixels PX through the plurality of gate lines GL, and the power source unit may supply power voltages to the pixels PX through power voltage supply lines.

The timing controller TD may control the data drive circuit DD and the gate drive circuit GD. For example, the timing controller TD may realign digital video data, which are inputted from the outside, to fit the resolution of the display panel PN and supply the video data to the data drive circuit DD.

The data drive circuit DD may convert digital video data, which are inputted from the timing controller TD, into analog data voltage on the basis of a data control signal and supply the analog data voltage to the plurality of data lines DL.

The gate drive circuit GD may generate a scan signal and a light emission signal in response to the gate control signal. For example, the gate drive circuit GD may include a scan driver and a light emission signal driver. The scan driver may generate scan signals in a row-sequential manner to operate at least one scan line connected to each pixel row and supply the scan signals to scan lines. The light emission signal driver may generate light emission signals in a row-sequential manner to operate at least one light emission signal line connected to each pixel row and supply the light emission signals to light emission signal lines.

According to an embodiment, the gate drive circuit GD may be disposed on the display panel PN in a gate-driver-in-panel (GIP) manner. For example, the gate drive circuit GD may be divided into a plurality of gate drive circuits and respectively disposed on at least two side surfaces of the display panel PN. However, the disclosed concepts are not limited thereto, and in some embodiments, the gate drive circuit GD may be implemented as a chip-on-glass (COG) manner, a chip-on-film (COF) manner, and a tape-carrier-package (TCP) manner.

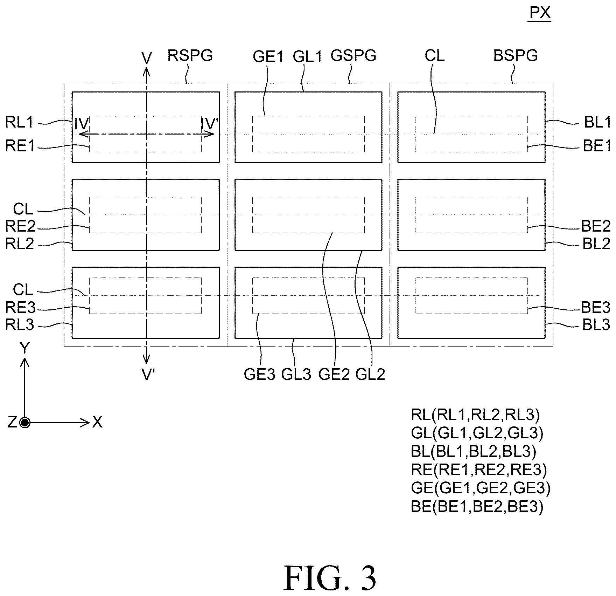

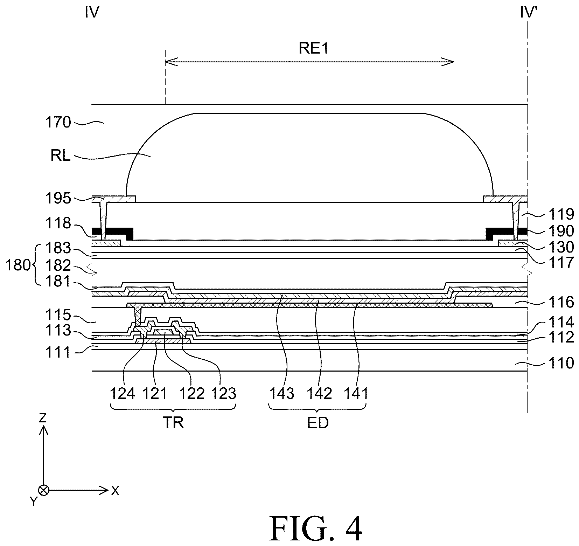

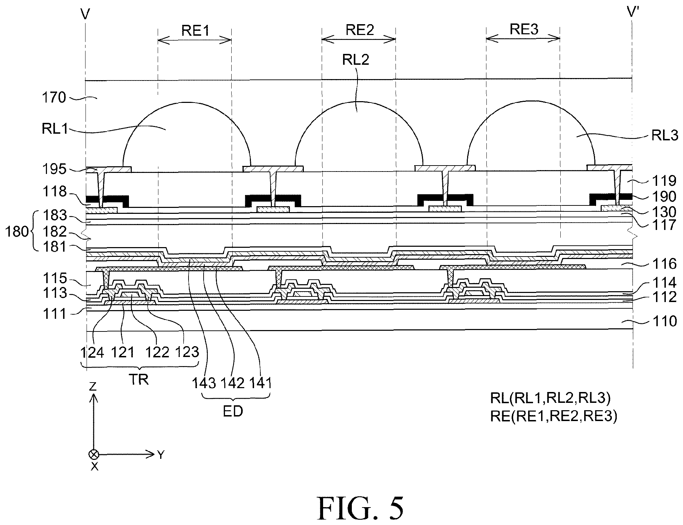

FIG. 3 is an enlarged top plan view of a pixel included in the display device according to an embodiment of the present disclosure. FIG. 4 is a cross-sectional view illustrating an example taken along line IV-IV' in FIG. 3. FIG. 5 is a cross-sectional view illustrating an example taken along line V-V' in FIG. 3.

FIG. 3 illustrates a subpixel layout in the X-Y plane of the pixel PX according to an embodiment for the case that the pixel PX includes three subpixel groups, e.g., a first subpixel group RSPG, a second subpixel group GSPG, and a third subpixel group BSPG.

In an embodiment, FIG. 4 illustrates a pixel in which a first optical member RL1 of the first subpixel group RSPG is disposed in one embodiment of the display device 100 taken along line IV-IV' in FIG. 3, a cross section in an X-Z plane. FIG. 5 illustrates a pixel in which a first optical member RL1, a second optical member RL2, and a third optical member RL3 of a first subpixel group RSPG are disposed in one embodiment of the display device 100 taken along line V-V' in FIG. 3, a cross section in a Y-Z plane.

For convenience of description, FIGS. 4 and 5 illustrate an area corresponding to only the first subpixel group RSPG among the three subpixel groups RSPG, GSPG, and BSPG illustrated in FIG. 3. However, the other subpixel groups GSPG and BSPG may also be formed in the same configuration.

For convenience of description, hereinafter, a thickness direction of a screen of display device 100 is denoted by dimension Z of a Cartesian X-Y-Z space, and subpixels as well as pixels can be laid out in an X-Y plane that is perpendicular to the Z axis. In some embodiments, the Y axis of this space can conveniently correspond to a vertical direction on the screen of the display device.

With reference to FIG. 3, a pixel PX may include a plurality of subpixel groups RSPG, GSPG, and BSPG configured to exhibit different colors, each subpixel group including a plurality of subpixels. For example, the pixel PX may include the first subpixel group RSPG including a plurality of red subpixels configured to emit light of a red color, the second subpixel group GSPG including a plurality of green subpixels configured to emit light of a green color, and the third subpixel group BSPG including a plurality of blue subpixels configured to emit light of a blue color. For convenience, the first subpixel group RSPG may be referred to as a red subpixel group, the second subpixel group GSPG may be referred to as a green subpixel group, and the third subpixel group BSPG may be referred to as a blue subpixel group. In certain embodiments, each subpixel group includes three subpixels, where each subpixel of a given subpixel group emits light of the same color. In embodiments, a subpixel group emits light only when a signal provided to that subpixel group is consistent with a light emission instruction.

Referring again to FIG. 3, in one pixel PX, the subpixel groups RSPG, GSPG, and BSPG may be disposed side by side to form a subpixel line (row) parallel to the X axis. For example, the first subpixel group RSPG, the second subpixel group GSPG, and the third subpixel group BSPG may be sequentially disposed in the X direction. However, the present disclosure is not limited thereto. In other embodiments of a pixel PX of the disclosure, other arrangement orders of the first subpixel group RSPG, the second subpixel group GSPG, and the third subpixel group BSPG in a line parallel to the X axis may be used, as necessary.

The subpixel groups RSPG, GSPG, and BSPG may each include a plurality of subpixels configured to emit light beams having the same color. In addition, first light-emitting areas RE1, GE1, and BE1, second light-emitting areas RE2, GE2, and BE2, and third light-emitting areas RE3, GE3, and BE3, are respectively disposed in the plurality of subpixels, which, in this example, are arranged along a line parallel to the X axis. For example, with reference to FIG. 3, the first subpixel group RSPG includes a first subpixel, a second subpixel, and a third subpixel that emit light beams with the same color (red). In addition, within the first subpixel group RSPG, the first subpixel includes a first light-emitting area RE1, the second subpixel includes a second light-emitting area RE2, and the third subpixel includes a third light-emitting area RE3. The second subpixel group GSPG may include a first subpixel, a second subpixel, and a third subpixel that emit light beams with the same color (green). In addition, within the second subpixel group GSPG, the first subpixel includes a first light-emitting area GE1, the second subpixel includes a second light-emitting area GE2, and the third subpixel includes a third light-emitting area GE3. The third subpixel group BSPG may include a first subpixel, a second subpixel, and a third subpixel that emit light beams with the same color (blue). Within the third subpixel group BSPG, the first subpixel includes a first light-emitting area BE1, the second subpixel includes a second light-emitting area BE2, and the third subpixel includes a third light-emitting area BE3.

In embodiments shown in FIG. 3, in the first subpixel group RSPG, the first subpixel, the second subpixel, and the third subpixel may be disposed side by side along a line parallel to the Y axis. Therefore, the first light-emitting area RE1, the second light-emitting area RE2, and the third light-emitting area RE3 may be disposed side by side in a Y direction parallel to the Y axis. In the second subpixel group GSPG, the first subpixel, the second subpixel, and the third subpixel may be disposed side by side, also in a Y direction parallel to the Y axis. Correspondingly, the first light-emitting area GE1, the second light-emitting area GE2, and the third light-emitting area GE3 may be disposed side by side in a Y direction parallel to the Y axis. In the third subpixel group BSPG, the first subpixel, the second subpixel, and the third subpixel may be disposed side by side, also in a Y direction parallel to the Y axis. Correspondingly, the first light-emitting area BE1, the second light-emitting area BE2, and the third light-emitting area BE3 may be disposed side by side in a Y direction parallel to the Y axis.

In embodiments of the configuration shown in FIG. 3, the first subpixels of each of the subpixel groups RSPG, GSPG, and BSPG may be disposed side by side in an X direction parallel to the X axis. Correspondingly, the first light-emitting areas RE1, GE1, and BE1 of the subpixel groups RSPG, GSPG, and BSPG may be disposed side by side in an X direction parallel to the X axis. In addition, the second subpixels of the subpixel groups RSPG, GSPG, and BSPG may be disposed side by side in an X direction parallel to the X axis. Correspondingly, the second light-emitting areas RE2, GE2, and BE2 of the subpixel groups RSPG, GSPG, and BSPG may be disposed side by side in an X direction parallel to the X axis. In a similar way, the third subpixels of the subpixel groups RSPG, GSPG, and BSPG may be disposed side by side in an X direction parallel to the X axis. Correspondingly, the third light-emitting areas RE3, GE3, and BE3 of the subpixel groups RSPG, GSPG, and BSPG may be disposed side by side in an X direction parallel to the X axis.

Still referring to FIG. 3, in this scheme, in one pixel PX, light-emitting areas RE, GE, and BE, which emit light beams with different colors, may be disposed side by side in an X direction parallel to the X axis. In addition, the light-emitting areas E1, E2, and E3 in each of the three respective subpixel groups, which emit light beams with the same color, may be disposed side by side in a Y direction parallel to the Y axis.

In embodiments shown in FIG. 3, a plurality of optical members RL, GL, and BL are disposed in each of the subpixel groups RSPG, GSPG, and BSPG to overlap the light-emitting areas RE, GE, and BE when observed along a line of sight parallel to the Z axis. For example, with reference to FIG. 3, the plurality of optical members RL, which respectively correspond to the plurality of light-emitting areas RE, have shapes that entirely enclose the light-emitting areas of subpixel group RSPG when both are projected onto the X-Y plane of the subpixel layout. Similar relationships can be noted for the other subpixel groups GSPG and BSPG.

As in embodiments shown by FIG. 3, the optical members RL, GL, and BL, projected into the X-Y plane, may have a substantially rectangular shape with long dimensions extending parallel to the X axis and corresponding to the shapes, also viewed in the X-Y plane as a substantially rectangular shape having long dimensions parallel to the X axis, of the light-emitting areas RE, GE, and BE. For example, a planar shape of each of the optical members RL, GL, and BL may be substantially a bar shape with long dimension extending parallel to the X axis.

Referring to FIG. 3, in the subpixel groups RSPG, GSPG, and BSPG, at least some of the optical members RL, GL, and BL can be shifted in position relative to the corresponding light-emitting areas in a first direction or a second direction (one direction or the other) along a line parallel to the Y axis. Light-emitting areas RE2, GE2, and BE2 all have geometric centers that coincide with the geometric centers of the corresponding optical members when the comparison is made by viewing along the Z axis and projecting onto an X-Y plane. Comparing with RE2, GE2, and BE2, the remaining light-emitting areas of FIG. 3 are shifted in position relative to the corresponding optical members in a first direction (RE1, GE1, BE1) or in a second direction (RE3, GE3, BE3) parallel to the Y axis. The geometric centers of optical members RL1, RL3, GL1, GL3, BL1, and BL3 are offset relative to the geometric centers of the corresponding light-emitting areas when projections in the X-Y plane are compared.

As shown in FIG. 3, in the subpixel groups RSPG, GSPG, and BSPG, the first light-emitting areas RE1, GE1, and BE1 may be disposed side by side parallel to the X axis. Then, the optical members RL1, GL1, and BL1 respectively corresponding to the first light-emitting areas RE1, GE1, and BE1 may also be disposed side by side parallel to the X axis. In FIG. 3, the optical members RL1, GL1, and BL1, which are shifted relative to the corresponding light-emitting areas (or the corresponding center lines CL) in the same direction parallel to the Y axis, may be disposed in the same row in the X-Y plane in one pixel PX. In addition, the second optical members RL2, GL2, and BL2, which have geometric centers disposed to be coincident with the centers of the second light-emitting areas RE2, GE2, and BE2 when projections along a Z direction into an X-Y plane are considered, may be disposed in a second row in the X-Y plane of the subpixel array. Further, the third optical members RL3, GL3, and BL3, which are shifted relative to the corresponding light-emitting areas (or the corresponding center lines CL) in a second, opposite to the first, direction along a line parallel to the Y axis, may be disposed in a third row.

With reference to FIGS. 4 and 5 together, the display device 100 according to an embodiment of the present disclosure may include a substrate 110, a buffer film 111, a gate insulation film 112, a first interlayer insulation film 113, a lower protective film 114, an overcoating layer 115, a bank 116, transistors TR, light-emitting elements ED, an encapsulation member 180, a second interlayer insulation film 118, a black matrix 190, touch electrodes 195, the optical member RL, and an optical member protection film 170.

In some embodiments, the substrate 110 may include an insulating material. In some embodiments, the substrate 110 may include a transparent material. For example, the substrate 110 may include glass or plastic.

The buffer film 111 may be disposed on the substrate 110. The buffer film 111 may include an insulating material. For example, the buffer film 111 may include an inorganic insulating material such as silicon oxide (SiOx) and/or silicon nitride (SiNx). The buffer film 111 may have a multilayer structure. For example, the buffer film 111 may have a stacked structure and can include a film made of silicon nitride (SiNx) and/or a film made of silicon oxide (SiOx).

The buffer film 111 may be positioned between the substrate 110 and a drive part of each of the subpixel groups RSPG, GSPG, and BSPG. The buffer film 111 may suppress contamination of the drive part caused by proximity to the substrate 110 during a process of forming the drive part. For example, a top surface of the substrate 110, which is directed toward the drive part of each of the subpixel groups RSPG, GSPG, and BSPG, may be covered by the buffer film 111. As the display device is fabricated, the drive part of each of the subpixel groups RSPG, GSPG, and BSPG may be positioned on the buffer film 111.

The gate insulation film 112 may be disposed on the buffer film 111. The gate insulation film 112 may include an insulating material. For example, the gate insulation film 112 may include an inorganic insulating material such as silicon oxide (SiO) and/or silicon nitride (SiN). The gate insulation film 112 may include a material having high permittivity. For example, the gate insulation film 112 may include a high-K material such as hafnium oxide (HfO). The gate insulation film 112 may have a multilayer structure.

The first interlayer insulation film 113 may be disposed on the gate insulation film 112. The first interlayer insulation film 113 may include an insulating material. For example, the first interlayer insulation film 113 may include an inorganic insulating material such as silicon oxide (SiO) and silicon nitride (SiN). The first interlayer insulation film 113 may extend between a gate electrode 122 and a source electrode 123 of the transistor TR and between the gate electrode 122 and a drain electrode 124 of the transistor TR. For example, the source electrode 123 and the drain electrode 124 of the transistor TR may be insulated from the gate electrode 122 by the first interlayer insulation film 113. The first interlayer insulation film 113 may cover the gate electrode 122 of the transistor TR. The source electrode 123 and the drain electrode 124 of each of the subpixel groups RSPG, GSPG, and BSPG may be positioned on the first interlayer insulation film 113. The gate insulation film 112 and the first interlayer insulation film 113 may expose a source area and a drain area of each semiconductor layer 121 positioned in each of the subpixel groups RSPG, GSPG, and BSPG.

The lower protective film 114 may be disposed on the first interlayer insulation film 113. The lower protective film 114 may include an insulating material. For example, the lower protective film 114 may include an inorganic insulating material such as silicon oxide (SiO) and/or silicon nitride (SiN).

The lower protective film 114 may suppress damage to the drive part caused by external moisture and impact. The lower protective film 114 may extend along a surface of the transistor TR. The lower protective film 114 may be in contact with the first interlayer insulation film 113 outside the drive part positioned in each of the subpixel groups RSPG, GSPG, and BSPG.

The overcoating layer 115 may be disposed on the lower protective film 114. The overcoating layer 115 may include an insulating material. The overcoating layer 115 may include a material different from the material of the lower protective film 114. For example, the overcoating layer 115 may include an organic insulating material.

The overcoating layer 115 may remove a level difference caused by the drive part of each of the subpixel groups RSPG, GSPG, and BSPG, in which a surface of the lower protective film 114 included a bump where each transistor was formed underneath. For example, a top surface of the overcoating layer 115, which is opposite to the substrate 110, may be a flat surface.

The transistor TR may be disposed on the substrate 110. The transistor TR may be provided as a plurality of transistors TR respectively corresponding to the plurality of subpixels included in each of the subpixel groups RSPG, GSPG, and BSPG. However, the present disclosure is not limited thereto. In some embodiments, a drain electrode of each driving transistor TR can be electrically connected to a corresponding first electrode 141 of the light-emitting element ED of each subpixel.

The transistor TR may include a semiconductor layer 121, a gate electrode 122, a source electrode 123, and a drain electrode 124.

For example, a semiconductor layer 121 may be positioned between the buffer film 111 and the gate insulation film 112, and the gate electrode 122 may be positioned between the gate insulation film 112 and the first interlayer insulation film 113. A source electrode 123 and a drain electrode 124 may be positioned between the first interlayer insulation film 113 and the lower protective film 114. A gate electrode 122 may overlap a channel area of the semiconductor layer 121. The source electrode 123 may be electrically connected to the source area of the semiconductor layer 121. The drain electrode 124 may be electrically connected to the drain area of the semiconductor layer 121.

A plurality of light-emitting elements ED may be disposed in each of the subpixel groups RSPG, GSPG, and BSPG. For example, the light-emitting elements ED may be disposed to respectively correspond to the plurality of subpixels included in each of the subpixel groups RSPG, GSPG, and BSPG. The first subpixel group RSPG will be described as an example. The plurality of light-emitting elements ED may be disposed to respectively correspond to the first subpixel, the second subpixel, and the third subpixel included in the first subpixel group RSPG. The light-emitting element ED may be disposed on the overcoating layer 115 of the corresponding subpixel group among the subpixel groups RSPG, GSPG, and BSPG. For example, the first electrode 141 of the light-emitting element ED may be electrically connected to the drain electrode 124 or the source electrode 123 of the transistor TR through contact holes formed through the lower protective film 114 and the overcoating layer 115.

The light-emitting element ED may emit light with a specific color. For example, the light-emitting element ED may include the first electrode 141, a light-emitting layer 142, and a second electrode 143 sequentially stacked on the substrate 110.

The first electrode 141 may include an electrically conductive material. The first electrode 141 may include a material having high reflectance. For example, the first electrode 141 may include metal such as aluminum (Al) and silver (Ag). The first electrode 141 may have a multilayer structure. For example, the first electrode 141 may have a structure in which a reflective electrode, which is made of metal, is positioned between transparent electrodes made of a transparent conductive material such as indium tin oxide (ITO) and/or indium zinc oxide (IZO). The first electrode 141 may be electrically connected to the drain electrode 124 of the transistor TR through contact holes formed through the lower protective film 114 and the overcoating layer 115.

The light-emitting layer 142 may emit light with luminance corresponding to a voltage difference between the first electrode 141 and the second electrode 143. For example, the light-emitting layer 142 may include an emission material layer (EML) including a light-emitting material. The light-emitting material may include an organic material, an inorganic material, or an organometallic material.

The light-emitting layer 142 may have a multilayer structure. For example, the light-emitting layer 142 may further include at least one of a hole injection layer (HIL), a hole transport layer (HTL), an electron transport layer (ETL), and an electron injection layer (EIL).

The second electrode 143 may include an electrically conductive material. The second electrode 143 may include a material different from the material of the first electrode 141. A transmittance rate of the second electrode 143 may be higher than a transmittance rate of the first electrode 141. For example, the second electrode 143 may be configured as a transparent electrode made of a transparent conductive material such as ITO and/or IZO. Thus, in the display device 100 according to an embodiment of the present disclosure, light emitted by the light-emitting layer 142 may pass through the second electrode 143.

The first electrodes 141 in each of the subpixel groups RSPG, GSPG, and BSPG may be spaced apart from one another. For example, with reference to FIG. 3, the bank 116 may be disposed between the first electrodes 141 of the plurality of subpixels of the first subpixel group RSPG and the plurality of subpixels of the second subpixel group GSPG. In addition, the bank 116 may be disposed between the plurality of subpixels of the second subpixel group GSPG and the plurality of subpixels of the third subpixel group BSPG. Further, in each of the subpixel groups RSPG, GSPG, and BSPG, the first electrodes 141 of the first subpixel, the second subpixel, and the third subpixel may be spaced apart from one another. In each of the subpixel groups RSPG, GSPG, and BSPG, the bank 116 may be disposed between the first electrodes 141 of the first subpixel, the second subpixel, and the third subpixel. In some embodiments, the bank 116 may be disposed to cover two opposite ends of the first electrodes 141 spaced apart from each other. In some embodiments, the bank 116 may include an insulating material. For example, the bank 116 may include an organic insulating material. Thus, the first electrodes 141, which are spaced apart from each other, may be insulated from each other by the bank 116. The bank 116 may include a material different from the material of the overcoating layer 115. However, the present disclosure is not limited thereto.

In each of the subpixel groups RSPG, GSPG, and BSPG, the bank 116 may separate the first light-emitting areas RE1, GE1, and BE1, the second light-emitting areas RE2, GE2, and BE2, and the third light-emitting areas RE3, GE3, and BE3 of the light-emitting elements ED. The first subpixel group RSPG will be described as an example. The first subpixel group RSPG may include a plurality of subpixels, and the first electrodes 141 may be disposed in the plurality of subpixels and spaced apart from one another. In some embodiments, the bank 116 may be disposed to cover an end of the first electrode 141 disposed in each of the subpixels. Therefore, a part of a top surface of the first electrode 141 of each of the subpixels between the two ends may be left exposed by deposition of the bank 116. As described above, the exposed top surfaces of the first electrodes 141 of the subpixels may be defined as the first light-emitting area RE1, the second light-emitting area RE2, and the third light-emitting area RE3.

The light-emitting layer 142 and the second electrode 143 of the light-emitting element ED positioned in each of the plurality of subpixels may be stacked in a partial area of the corresponding first electrode 141 left exposed by an opening in the bank 116. The first subpixel group RSPG will be described as an example. The light-emitting layers 142 and the second electrodes 143 may be stacked on the bank 116 and stacked in the first light-emitting area RE1, the second light-emitting area RE2, and the third light-emitting area RE3, the light-emitting areas being left exposed by openings in the bank 116.

The encapsulation member 180 may be positioned on the light-emitting element ED in each of the subpixel groups RSPG, GSPG, and BSPG. The encapsulation member 180 may suppress damage to the light-emitting element ED caused by moisture and impact from the outside. The encapsulation member 180 may have a multilayer structure. For example, the encapsulation member 180 may include a first encapsulation layer 181, a second encapsulation layer 182, and a third encapsulation layer 183 sequentially stacked. However, the present disclosure is not limited thereto.

The first encapsulation layer 181, the second encapsulation layer 182, and the third encapsulation layer 183 may include an insulating material. The second encapsulation layer 182 may include a material different from the material of the first encapsulation layer 181 and the third encapsulation layer 183. For example, the first encapsulation layer 181 and the third encapsulation layer 183 can be inorganic encapsulation layers including an inorganic insulating material, and the second encapsulation layer 182 can include an organic encapsulation layer including an organic insulating material. In this way, damage to the light-emitting element ED of the display device 100 caused by moisture and impact from the outside may be more effectively suppressed.

A touch buffer layer 117 may be disposed on the encapsulation member 180. The touch buffer layer 117 may be disposed between the encapsulation member 180 and a touch bridge electrode 130 and configured to insulate the touch bridge electrode 130. For example, the touch buffer layer 117 may include an insulating material. For example, the touch buffer layer 117 may be made of an organic insulating material or an inorganic insulating material. However, the present disclosure is not limited thereto.

The touch bridge electrode 130 may be disposed on the touch buffer layer 117. The touch bridge electrode 130 may electrically connect to the touch electrodes 195 on a second interlayer insulation film 118. In some embodiments, the touch bridge electrode 130 may include a metallic material such as titanium (Ti), aluminum (Al), silver (Ag), copper (Cu), or a magnesium-silver alloy (Mg:Ag). However, the present disclosure is not limited thereto.

The second interlayer insulation film 118 may be disposed on the touch bridge electrode 130. The second interlayer insulation film 118 may be disposed between the touch bridge electrode 130 and the black matrix 190 and configured to insulate the touch bridge electrode 130. The second interlayer insulation film 118 may include an insulating material. For example, the second interlayer insulation film 118 may include an organic insulating material or an inorganic insulating material. However, the present disclosure is not limited thereto.

The black matrix 190 may be disposed on the second interlayer insulation film 118. The black matrix 190 may be disposed between the plurality of subpixel groups RSPG, GSPG, and BSPG to reduce a mixture of colors of the plurality of subpixel groups RSPG, GSPG, and BSPG. In addition, the black matrix 190 may be disposed in each of the plurality of subpixel groups RSPG, GSPG, and BSPG to reduce a mixture of colors of the plurality of subpixels. Therefore, the black matrix 190 may be disposed to overlap the bank 116.

A third interlayer insulation film 119 may be disposed on the black matrix 190. The third interlayer insulation film 119 may include an insulating material. For example, the third interlayer insulation film 119 may include an organic insulating material or an inorganic insulating material. However, the present disclosure is not limited thereto.

A plurality of touch electrodes 195 may be positioned on the third interlayer insulation film 119. In the display area, the plurality of touch electrodes 195 may be disposed above the light-emitting elements ED. The plurality of touch electrodes 195 may be disposed on the third interlayer insulation film 119 and spaced apart from one another.

The plurality of touch electrodes 195 may be configured to sense a touch input applied from the outside by a user's finger, a touch pen, or the like. In some embodiments, the touch electrode 195 may include a metallic material such as titanium (Ti), aluminum (Al), silver (Ag), copper (Cu), or a magnesium-silver alloy (Mg:Ag). However, the present disclosure is not limited thereto.

The plurality of touch electrodes 195 may be disposed to overlap the bank 116 and the black matrix 190. Further, if the plurality of touch electrodes 195 includes an opaque metallic material, the plurality of touch electrodes 195 may also serve as barrier layers that restrict a path of light emitted from the light-emitting element ED. For example, the plurality of touch electrodes 195 may block light beams that propagate in a lateral direction among the light beams emitted from the light-emitting areas RE, GE, and BE. In particular, the plurality of touch electrodes 195, together with the optical member RL, may block the light beams that propagate in a lateral direction among the light beams emitted from each of the subpixel groups RSPG, GSPG, and BSPG. However, the present disclosure is not limited thereto.

The optical members RL, GL, and BL are disposed on the third interlayer insulation film 119.

The optical members RL, GL, and BL may be disposed on the third interlayer insulation film 119 and disposed on the same layer as the plurality of touch electrodes 195. For example, the optical members RL, GL, and BL may be disposed to cover edges of the plurality of touch electrodes 195. Therefore, ends of the optical members RL, GL and BL may be disposed on the plurality of touch electrodes 195.

The optical members RL, GL, and BL may be disposed to respectively correspond to the light-emitting areas RE, GE, and BE. The first subpixel group RSPG will be described as an example with reference to FIG. 5. The first optical member RL1 is disposed on the first light-emitting area RE1, the second optical member RL2 is disposed on the second light-emitting area RE2, and the third optical member RL3 is disposed on the third light-emitting area RE3. In this embodiment, the first optical member RL1 is disposed so that its projection onto the X-Y plane includes the first light-emitting area RE1 and is shifted relative to RE1 in the first direction parallel to the Y axis. In addition, the second optical member RL2 is disposed so that its projection onto the X-Y plane includes the second light-emitting area RE2 and the geometric center of RL2 as projected parallel to the Z axis onto the X-Y plane is coincident with the geometric center of RE2 as similarly projected onto the same X-Y plane. Further, the third optical member RL3 is disposed so that its projection onto the X-Y plane includes the third light-emitting area RE3 and is shifted relative to RE3 in the second, opposite to the first, direction parallel to the Y axis.

As described above, the optical members RL, GL, and BL are respectively disposed so that their projections parallel to the Z axis onto the X-Y plane include the light-emitting areas RE, GE, and BE, such that the light beams emitted by the light-emitting areas RE, GE, and BE may be emitted through the optical members RL, GL, and BL.

The optical members RL, GL, and BL may each have a shape that does not restrict the propagation of light in at least one side direction. The planar shape (shape of a projection in the X-Y plane) of each of the optical members RL, GL, and BL may be substantially rectangular with long dimensions parallel to the X axis. For example, the planar shape of each of the optical members RL, GL, and BL may be substantially a bar shape with long axis parallel to the X axis. Thus, the substantially rectangular planar shape of each of the optical members RL, GL, and BL may include long sides parallel to the X axis and short sides parallel to the Y axis.

In these embodiments, propagation directions of the light beams emitted from the light-emitting areas RE, GE, and BE of the subpixel groups RSPG, GSPG, and BSPG are not limited to the direction perpendicular to the light-emitting layer and parallel to the Z axis. For example, the content provided by the light beams emitted through the optical members RL, GL, and BL may be provided at a wide viewing angle where the direction of light propagation has both X and Z vector components in the Cartesian space.

In contrast, a width of each of the optical members RL, GL, and BL as measured parallel to the Y axis may be smaller than a width of each of the optical members RL, GL, and BL as measured parallel to the X axis. Therefore, the corresponding light beams emitted from the light-emitting areas RE, GE, and BE of the subpixel groups RSPG, GSPG, and BSPG may be inhibited from propagating in directions having Y component vectors. For example, the content provided by the light beams emitted through optical members RL, GL, and BL may be limited to smaller viewing angles if they have Y and Z component vectors than if they have X and Z component vectors.

At least a part of a top surface of a cross-sectional shape formed by cutting each of the optical members RL, GL, and BL in the first direction X may be flat. In addition, two opposite surfaces of each of the optical members RL, GL, and BL may be curved or straight. For example, with reference to FIG. 4, a cross-sectional shape defined based on a long side of the first optical member RL1 may include a top flat surface, and curved lines extending from two opposite ends of the flat surface toward the third interlayer insulation film 119. Alternatively, for example, the cross-sectional shape defined based on the long side of the first optical member RL1 may include a top flat surface, and straight lines perpendicularly extending from two opposite ends of the flat surface toward the third interlayer insulation film 119.

In addition, for example, with reference to FIG. 5, a cross-sectional shape defined based on a short side of each of the first optical member RL1, the second optical member RL2, and the third optical member RL3 may include only a curved line. In another example, a cross-sectional shape defined based on the short side of each of the first optical member RL1, the second optical member RL2, and the third optical member RL3 may be a semicircular shape. In yet another example, a cross-sectional shape defined based on the short side of each of the first optical member RL1, the second optical member RL2, and the third optical member RL3 may include a curved line and a straight line, such that at least a part of a top surface of a cross-sectional shape formed by cutting each of the first, second, and third optical members RL1, RL2, and RL3 in the first direction X may be flat.

The optical members RL, GL, and BL may each have a larger size than each of the light-emitting areas RE, GE, and BE of the subpixel groups RSPG, GSPG, and BSPG. Therefore, it is possible to improve the efficiency of light emitted from the light-emitting areas RE, GE, and BE of the subpixel groups RSPG, GSPG, and BSPG.

Although not illustrated in the drawings, an organic or inorganic insulation layer may be further disposed between the plurality of touch electrodes 195 and the optical member RL. However, the present disclosure is not limited thereto.

The optical member protection film 170 may be positioned on the optical member RL. The optical member protection film 170 may include an insulating material. For example, the optical member protection film 170 may include an organic insulating material. A refractive index of the optical member protection film 170 may be smaller than a refractive index of the optical member RL. Therefore, because of a difference in refractive index between the optical member RL and the optical member protection film 170, the light having passed through the optical member RL may not be reflected in the direction toward the substrate 110. If the display device is disposed on at least a part of the dashboard of the vehicle and provides the content to the user, e.g., a driver and a passenger, the display device may be positioned approximately below a line of sight of the user. Further, for example, a structure, such as a windshield, may be disposed above the display device. Therefore, the content emitted from the display device may be reflected by the structure disposed above the display device. When the image emitted from the display device is reflected by an external structure, as described above, both the image, which is emitted from the display device, and the reflected image are visually recognized by the user, which may degrade the visibility of the image and interfere with the driver's operation of the vehicle.

Therefore, in the display device 100 according to an embodiment of the present disclosure, the light-emitting areas RE, GE, and BE and the optical members RL, GL, and BL each have substantially a rectangular shape with long dimension parallel to the X axis and short dimension parallel to the Y axis. In the context of a screen of a display device in a car, the Y axis can be vertical, the X axis can be horizontal, and the Z axis can extend perpendicular to and away from the flat screen. In this example, the viewing angle that changes when the observer moves vertically relative to the screen may have a smaller working range than does the viewing angle that changes when the observer moves horizontally relative to the screen, where the working range is the range within which the screen image can be perceived. As described above, the display device 100 according to embodiments making use of light-emitting areas and optical members having substantially rectangular projections onto the X-Y plane may restrict the viewing angle for light propagation directions havingY and Z component vectors, thereby inhibiting the image from being reflected by an upper structure. In this way, the visibility of the display device 100 when used in an automotive cockpit may be improved.

When the display device operates repeatedly, heat may be expected to be generated from the light-emitting elements of the display device. When heat is consistently generated from the light-emitting elements, some of the light-emitting elements may be degraded. The degradation of the light-emitting elements may decrease the light-emitting areas of the degraded light-emitting elements. However, the degradation does not occur on all of the light-emitting elements. For example, some of the light-emitting elements may be degraded and thus have decreased light-emitting areas, but the other light-emitting elements may not be degraded. When the degree of degradation varies depending on the light-emitting element, the degree to which the light-emitting area decreases may also vary depending on the light-emitting element and this may cause luminance differences between light-emitting areas.

The display device 100 according to embodiments of the present disclosure includes the light-emitting areas RE, GE, and BE respectively disposed in the subpixel groups RSPG, GSPG, and BSPG, and the plurality of optical members RL, GL, and BL disposed to respectively correspond to the light-emitting areas RE, GE, and BE. In addition, in the subpixel groups RSPG, GSPG, and BSPG, the first optical members RL1, GL1, and BL1 are shifted relative to the corresponding light-emitting areas in a first direction parallel to the Y axis, the second optical members RL2, GL2, and BL2 are not so shifted and their geometric centers remain aligned with the geometric centers of the second light-emitting areas RE1, GE2, and BE2 along a line parallel to the Z axis, and the third optical members RL3, GL3, and BL3 are shifted relative to the corresponding light-emitting areas in a second, opposite to the first, direction parallel to the Y axis.

As described above, according to embodiments, the optical members RL, GL, and BL are initially disposed at different positions relative to the light-emitting areas RE, GE, and BE, and relative positions of the light-emitting areas RE, GE, and BE finally remaining after degradation may vary.

The first subpixel group RSPG will be described as an example. Even when the second light-emitting area RE2, which has its geometric center aligned with the geometric center of the second optical member RL2, is degraded and decreased, the geometric center of the degraded second light-emitting area RE2 may still remain aligned with the geometric center of the second optical member RL2.

Because the first optical member RL1 is shifted in the first direction along the Y axis relative to the geometric center of the first light-emitting area RE1, the first light-emitting area RE1 may be disposed to be relatively biased in the second direction along the Y axis relative to the center of the first optical member RL1. Even though the first light-emitting area RE1 is degraded and decreased, the relative shift between the optical member and the corresponding light-emitting area may remain. The first light-emitting area RE1, which is disposed to be biased in the second direction along the Y axis as described above, may compensate for a degraded part of the area of the second light-emitting area RE2.

Next, because the third optical member RL3 is shifted in the second direction along the Y axis relative to the geometric center of the third light-emitting area RE3, the third light-emitting area RE3 may be disposed to be relatively biased in the first direction along the Y axis relative to the geometric center of the third optical member RL3. Even though the third light-emitting area RE3 is degraded and decreased, the third light-emitting area RE3 may still be disposed to be biased in the first direction along the Y axis relative to the geometric center of the third optical member RL3. The third light-emitting area RE3, which is disposed to be biased in the first direction along the Y axis as described above, may compensate for a part of the area of the second light-emitting area RE2 that is degraded.

As described above, in the display device 100 according to the embodiment of the present disclosure, some of the degraded areas may complement one another even though the light-emitting areas RE, GE, and BE are individually degraded and decreased. In this way, in the display device 100 according to embodiments of the present disclosure, the luminance difference between the degraded and non-degraded light-emitting areas may be reduced even though the light-emitting areas are individually degraded and decreased.

Therefore, the display device 100 according to embodiments of the present disclosure may inhibit unwanted patterns, such as stains, from being visually recognized because of the luminance difference between the non-degraded light-emitting areas RE, GE, and BE and the degraded light-emitting areas RE, GE, and BE. The relative position differences between subpixels for the light-emitting areas are also beneficial in obscuring unwanted patterns. Therefore, the display device 100 according to embodiments of the present disclosure may provide images with higher quality at various viewing angles regardless of the degree of degradation.

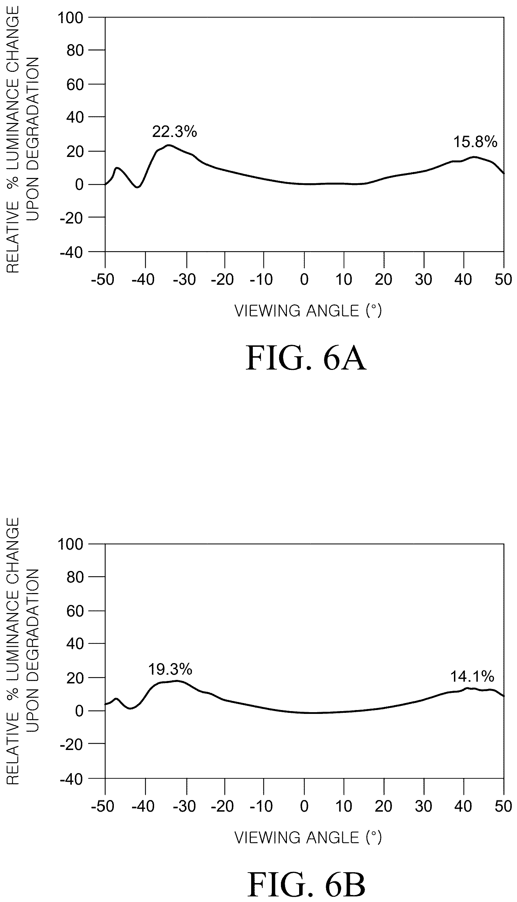

FIG. 6A is a graph illustrating percent luminance difference between degraded and non-degraded samples as a function of viewing angle in a comparative example of the present disclosure. FIG. 6B is a graph illustrating percent luminance difference between degraded and non-degraded samples as a function of viewing angle in the display device according to the embodiment of the present disclosure. For both plots, compensation was done to adjust the luminance difference between degraded and non-degraded samples to zero at zero viewing angle (line of sight along a perpendicular from the device screen).

Specifically, FIGS. 6A and 6B illustrate results of measuring and comparing values of luminance of the non-degraded light-emitting areas and values of luminance of the degraded light-emitting areas for the display devices of the comparative example and another embodiment of the present disclosure. In this case, front compensation was performed to correct the luminance difference between the non-degraded light-emitting area and the degraded light-emitting area to 0 in a forward direction, i.e., a direction in which the viewing angle is 0°. Then, the luminance value for the degraded light-emitting area was converted to a percentage (%) based on the luminance value in the non-degraded light-emitting area and presented. In this case, the degraded light-emitting area refers to a light-emitting area formed by operating the light-emitting element at a brightness of 800 nits for 1,500 hours at a temperature of 65°C.

FIG. 6A is a graph showing an experimental result of the comparative example of the present disclosure. In this case, the comparative example refers to a display device in which all the optical members are disposed with no shift from a position in which their geometric centers are aligned with the geometric centers of the light-emitting areas along a line parallel to the Z axis. Specifically, in the present disclosure, the comparative example refers to a display device in which the arrangements of the subpixel groups, the light-emitting areas, and the optical members are identical to those of the display device 100 in FIGS. 1 to 5A, but the optical members are not shifted. On the front surface with a viewing angle of 0, there is no luminance difference between the non-degraded and degraded light-emitting areas because of front compensation performed during the experimental process. In contrast, it can be ascertained that a maximum luminance difference between the non-degraded and degraded light-emitting areas is about 15.8% at the upper-side viewing angle. In addition, it can be ascertained that a maximum luminance difference between the non-degraded and degraded light-emitting areas is about 22.3% at the lower-side viewing angle. As described above, it can be ascertained that even though the front compensation is performed, the luminance difference between the non-degraded and degraded light-emitting areas is observed at the peripheral viewing angles.

FIG. 6B is a graph showing an experimental result of the embodiment of the present disclosure. If, in the subpixel groups RSPG, GSPG, and BSPG, the positions of optical members are shifted or not shifted relative to light-emitting areas according to embodiments of the present disclosure, a maximum luminance difference between the non-degraded and degraded light-emitting areas is about 14.1% at the upper-side viewing angle. As described above, compared to the comparative example in FIG. 6A, the display device 100 according to the embodiment of the present disclosure shows a decreased luminance difference between the non-degraded and degraded light-emitting areas at the upper-side viewing angle. In addition, it can be ascertained that a maximum luminance difference between the non-degraded and degraded light-emitting areas is about 19.3% at the lower-side viewing angle. As described above, compared to the comparative example in FIG. 6A, the display device 100 according to the embodiment of the present disclosure shows a decreased luminance difference between the non-degraded and degraded light-emitting areas at the lower-side viewing angle.

Therefore, compared to the comparative example, the display device 100 according to embodiments of the present disclosure shows a decreased luminance difference between non-degraded and degraded light-emitting areas at the peripheral viewing angles.

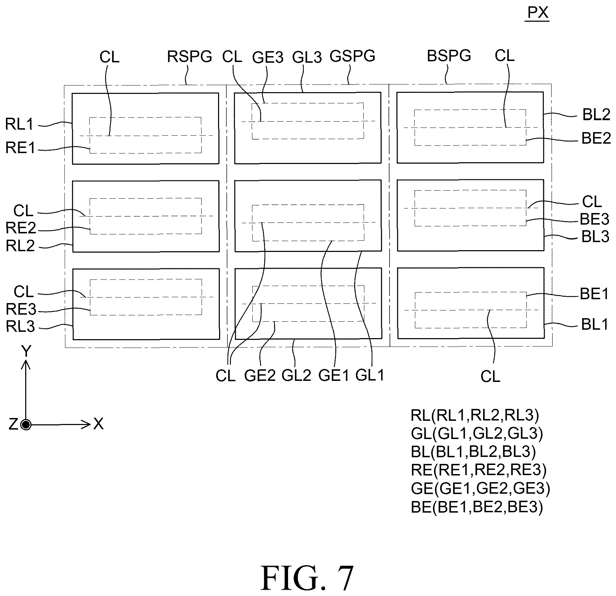

FIG. 7 is an enlarged top plan view of a pixel included in a display device according to another embodiment of the present disclosure.

A display device in FIG. 7 is substantially identical in configuration to the display device 100 in FIGS. 1 to 5, except for relative positions of the optical members RL, GL, and BL and the light-emitting areas RE, GE, and BE on the plane. Therefore, a repeated description of the detailed structure of a subpixel and the overall architecture of the display device will be omitted.

With reference to FIG. 7, in one pixel PX, the subpixel groups RSPG, GSPG, and BSPG may be disposed side by side parallel to the X axis. For example, the first subpixel group RSPG, the second subpixel group GSPG, and the third subpixel group BSPG may be sequentially disposed in a row parallel to the X axis. However, the present disclosure is not limited thereto. In one pixel PX, the arrangement order of the first subpixel group RSPG, the second subpixel group GSPG, and the third subpixel group BSPG may be changed, as necessary.

In the subpixel groups RSPG, GSPG, and BSPG, at least some of the optical members RL, GL, and BL are shifted relative to the corresponding light-emitting areas RE, GE, and BE in one direction or the other along lines parallel to the Y axis. The subpixel groups RSPG, GSPG, and BSPG include the first optical members RL1, GL1, and BL1 shifted relative to the corresponding light-emitting areas RE1, GE1, and BE1 (or corresponding center lines CL) in the first direction parallel to the Y axis. Further, the subpixel groups RSPG, GSPG, and BSPG include the second optical members RL2, GL2, and BL2 disposed so that the geometric centers thereof are aligned with the geometric centers of the second light-emitting areas RE2, GE2, and BE2 when considered as projections along a Z axis direction onto an X-Y plane. In addition, the subpixel groups RSPG, GSPG, and BSPG include the third optical members RL3, GL3, and BL3 shifted relative to the corresponding light-emitting areas RE3, GE3 and BE3 (or corresponding center lines CL) in the second direction parallel to the Yaxis.

In the display device according to another embodiment of the present disclosure, in the first subpixel group RSPG, the first light-emitting area RE1, the second light-emitting area RE2, and the third light-emitting area RE3 may be sequentially disposed in the second direction parallel to the Y axis. Therefore, in the first subpixel group RSPG, the first optical member RL1, the second optical member RL2, and the third optical member RL3 may also be sequentially disposed in the second direction parallel to the Yaxis.

In addition, in the second subpixel group GSPG, the third light-emitting area GE3, the first light-emitting area GE1, and the second light-emitting area GE2 may be sequentially disposed in the second direction parallel to the Y axis. Therefore, in the second subpixel group GSPG, the third optical member GL3, the first optical member GL1, and the second optical member GL2 may also be sequentially disposed in the second direction parallel to the Yaxis.

Further, in the third subpixel group BSPG, the second light-emitting area BE2, the third light-emitting area BE3, and the first light-emitting area BE1 may be sequentially disposed in the second direction parallel to the Y axis. Therefore, in the third subpixel group BSPG, the second optical member BL2, the third optical member BL3, and the first optical member BL1 may also be sequentially disposed in the second direction parallel to the Yaxis.

Referring to FIG. 7 and as described above for an embodiment of the display device, in one pixel PX, all the relative positions of the optical members RL, GL, and BL and the light-emitting areas RE, GE, and BE disposed in the same row arranged parallel to the X axis may be different. For example, with reference to FIG. 7, in one pixel PX, the first optical member RL1 of the first subpixel group RSPG is shifted relative to RE1 (or the corresponding center line CL) in the first direction parallel to the Y axis, the third optical member GL3 of the second subpixel group GSPG is shifted relative to GE3 (or the corresponding center line CL) in the second direction parallel to the Y axis, and the second optical member BL2 of the third subpixel group BSPG, which is not shifted relative to BE2 parallel to the Y axis, may be disposed in the first row arranged parallel to the X axis. In addition, the second optical member RL2 of the first subpixel group RSPG, which is not shifted relative to RE2 (or the corresponding center line CL) parallel to the Y axis, the first optical member GL1 of the second subpixel group GSPG, which is shifted relative to GE1 (or the corresponding center line CL) in the first direction parallel to the Y axis, and the third optical member BL3 of the third subpixel group BSPG, which is shifted relative to BE3 (or the corresponding center line CL) in the second direction parallel to the Y axis, may be disposed in the second row arranged parallel to the X axis. Further, the third optical member RL3, which is shifted relative to RE3 (or the corresponding center line CL) in the second direction parallel to the Y axis, the second optical member GL2 of the second subpixel group GSPG, which is not shifted relative to GE2 in either direction parallel to the Y axis, and the first optical member BL1 of the third subpixel group BSPG, which is shifted relative to BE1 (or the corresponding center line CL) in the first direction parallel to the Y axis, may be disposed in the third row arranged parallel to the X axis.

In other embodiments and as described above, in the display device, the subpixel groups RSPG, GSPG, and BSPG can include the plurality of optical members RL, GL, and BL shifted in different directions relative to RE, GE and BE, such that the relative positions of the light-emitting areas RE, GE, and BE finally remaining after the degradation may vary. Therefore, some of the degraded areas may complement one another even though the light-emitting areas RE, GE, and BE are degraded and decreased. Therefore, in the display device according to another embodiment of the present disclosure, the luminance difference between the degraded and non-degraded light-emitting areas may be further reduced even though the light-emitting areas are degraded and decreased.

Therefore, the display device according to another embodiment of the present disclosure may further inhibit patterns, such as stains, from being visually recognized because of the luminance difference between the non-degraded light-emitting areas RE, GE, and BE and the degraded light-emitting areas RE, GE, and BE. Therefore, in comparison with the comparative example in which the geometric centers of all optical members are aligned with the geometric centers of all light-emitting areas when projected in a Z direction onto an X-Y plane, the display device according to another embodiment of the present disclosure may provide images with higher quality at various viewing angles regardless of the degree of degradation.

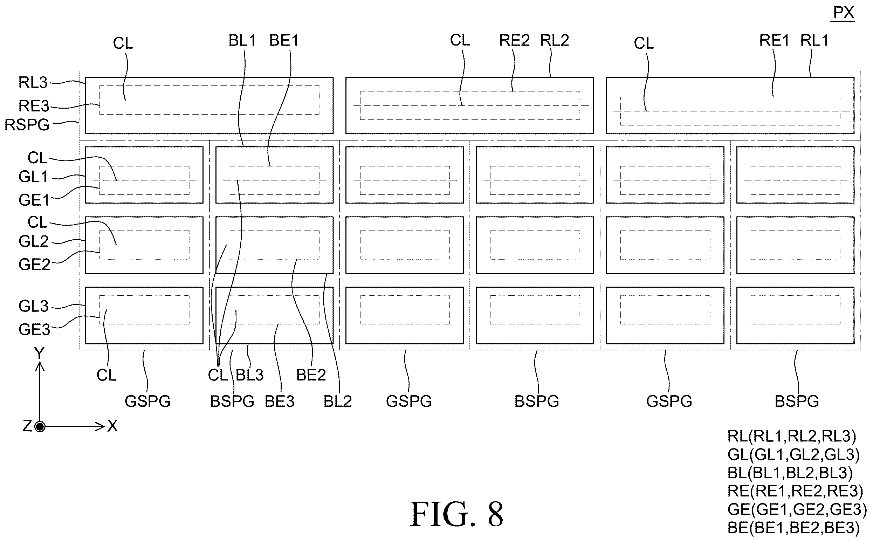

FIG. 8 is an enlarged top plan view of a pixel included in a display device according to still another embodiment of the present disclosure.

A display device in FIG. 8 is substantially identical in configuration to the display device 100 in FIGS. 1 to 5, except for positions of the subpixel groups RSPG, GSPG, and BSPG, the optical members RL, GL, and BL, and the light-emitting areas RE, GE, and BE on the plane. Therefore, a repeated description of the detailed structure of a subpixel and the overall architecture of the display device will be omitted.

In the subpixel groups RSPG, GSPG, and BSPG, at least some of the optical members RL, GL and BL are shifted relative to RE, GE and BE in the first direction parallel to the Y axis or the opposing second direction parallel to the Y axis. The subpixel groups RSPG, GSPG, and BSPG include the first optical members RL1, GL1, and BL1, which are shifted relative to RE1, GE1, and BE1 (or the corresponding center lines CL) in the first direction parallel to the Y axis. Further, the subpixel groups RSPG, GSPG, and BSPG include the second optical members RL2, GL2, and BL2, which are disposed so that the geometric centers thereof are aligned with the geometric centers of the second light-emitting areas RE2, GE2, and BE2 when projections in a Z direction onto an X-Y plane are considered. In addition, the subpixel groups RSPG, GSPG, and BSPG include the third optical members RL3, GL3, and BL3, which are shifted relative to RE3, GE3, and BE3 (or the corresponding center lines CL) in the second direction parallel to the Y axis.

In the display device according to still another embodiment of the present disclosure, one pixel PX may include one first subpixel group RSPG, a plurality of second subpixel groups GSPG, and a plurality of third subpixel groups BSPG.

In the display device according to still another embodiment of the present disclosure, the plurality of subpixels included in the first subpixel group RSPG may be disposed side by side along a line parallel to the X axis. Therefore, the plurality of light-emitting areas RE and the plurality of optical members RL included in the first subpixel group RSPG may also be disposed side by side along a line parallel to the X axis. For example, with reference to FIG. 8, in the first subpixel group RSPG, the third optical member RL3 is shifted relative to RE3 (or the corresponding center line CL) in the second direction parallel to the Y axis, the second optical member RL2, which is not shifted relative to RE2 in a Y axis direction, and the first optical member RL1 is shifted relative to RE1 (or the corresponding center line CL) in the first direction parallel to the Y axis, may be sequentially disposed along a line parallel to the X axis.

The plurality of subpixels included in the second subpixel group GSPG may be disposed side by side parallel to the Y axis. Therefore, the plurality of optical members GL and the plurality of light-emitting areas GE of the second subpixel group GSPG may be disposed side by side parallel to the Y axis. For example, with reference to the leftmost column of FIG. 8, in the first of three illustrated second subpixel groups GSPG, the first optical member GL1 is shifted relative to GE1(or the corresponding center line CL) in the first direction parallel to the Y axis, the second optical member GL2 is not shifted relative to GE2 in a Y axis direction, and the third optical member GL3 is shifted relative to GE3 (or the corresponding center line CL) in the second direction parallel to the Y axis, and they are sequentially disposed in the second direction parallel to the Y axis.

In addition, the plurality of second subpixel groups GSPG may each be disposed to interface with, in their location in the second direction parallel to the Y axis relative to RSPG, each of the plurality of subpixels included in the first subpixel group RSPG.

The plurality of subpixels included in the third subpixel group BSPG may be disposed side by side parallel to the Y axis. Therefore, the plurality of optical members BL and the plurality of light-emitting areas BE of the third subpixel group BSPG may be disposed side by side parallel to the Y axis. For example, with reference to the second column from the left in FIG. 8, in the third subpixel group BSPG, the first optical member BL1 is shifted relative to BE1 (or the corresponding center line CL) in the first direction parallel to the Y axis, the second optical member BL2 is not shifted relative to BE2 in a Y axis direction, and the third optical member BL3 is shifted relative to BE3 (or the corresponding center line CL) in the second direction parallel to the Y axis, and these may be sequentially disposed in the second direction parallel to the Y axis.

In addition, the plurality of third subpixel groups BSPG may each be disposed to interface with, in the second direction parallel to the Y axis, each of the plurality of subpixels included in the first subpixel group RSPG.

Further, the plurality of second subpixel groups GSPG and the plurality of third subpixel groups BSPG may be alternately disposed. For example, with reference to FIG. 8, the second subpixel groups GSPG and the third subpixel groups BSPG may be alternately disposed parallel to the X axis.

The optical members GL and BL that are shifted in the same direction relative to GE and BE in a Y axis direction may be disposed in the same row in the second subpixel groups GSPG and the third subpixel groups BSPG, as illustrated in the bottom three rows of FIG. 8. For example, with reference to FIG. 8, the first optical members GL1 and BL1, which are shifted relative to GE1 and BE1 (or the corresponding center lines CL) in the first direction parallel to the Y axis, may be disposed in the first row in the second subpixel group GSPG and the third subpixel group BSPG (first row below the RSPG row). Further, the second optical members GL2 and BL2, which are not shifted relative to GE2 and BE2 in a Y axis direction, may be disposed in the second row below the RSPG row. In addition, the third optical members GL3 and BL3, which are shifted relative to GE3 and BE3 (or the corresponding center lines CL) in the second direction parallel to the Y axis, may be disposed in the third row below the RSPG row.

As described above, in the display device according to still another embodiment of the present disclosure, the subpixel groups RSPG, GSPG, and BSPG include the plurality of optical members RL, GL, and BL shifted in different directions, such that the relative positions of the light-emitting areas RE, GE, and BE finally remaining after the degradation may vary. Therefore, some of the degraded areas may complement one another even though the light-emitting areas RE, GE, and BE are degraded and decreased. Therefore, in the display device according to another embodiment of the present disclosure, the luminance difference between the degraded and non-degraded light-emitting areas may be further reduced compared with that seen in a conventional display device design, even though the light-emitting areas are degraded and showing decreased luminance.

Therefore, the display device according to still another embodiment of the present disclosure may further inhibit patterns, such as stains, from being visually recognized because of the luminance difference between the non-degraded light-emitting areas RE, GE, and BE and the degraded light-emitting areas RE, GE, and BE. Therefore, the display device according to still another embodiment of the present disclosure may provide images with higher quality at various viewing angles regardless of the degree of degradation.

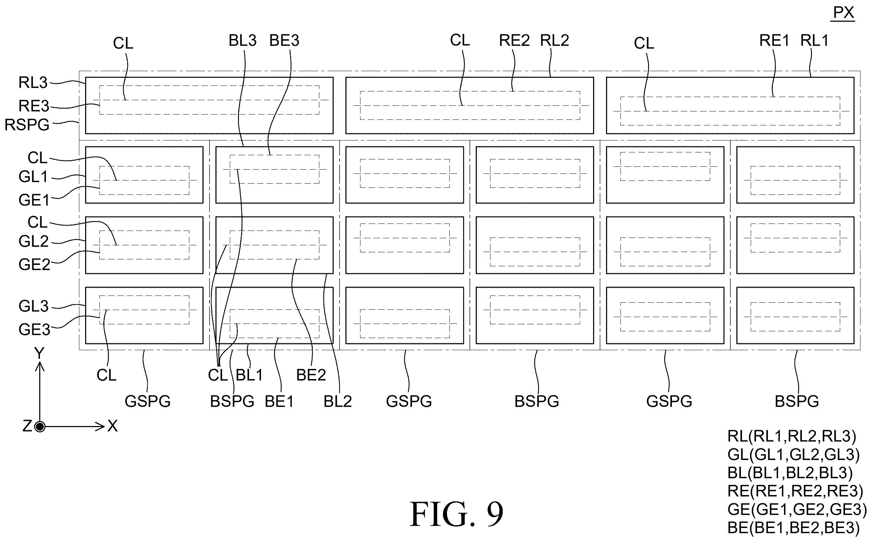

FIG. 9 is an enlarged top plan view of a pixel included in a display device according to yet another embodiment of the present disclosure.

A display device in FIG. 9 is substantially identical in configuration to the display device 100 in FIG. 8, except for the arrangements of the subpixel groups RSPG, GSPG, and BSPG, the optical members RL, GL, and BL, and the light-emitting areas RE, GE, and BE on the plane. Therefore, a repeated description of the detailed structure of a subpixel and the overall architecture of the display device will be omitted.

In the display device according to yet another embodiment of the present disclosure, the plurality of subpixels included in the first subpixel group RSPG may be disposed side by side parallel to the X axis. Therefore, the plurality of light-emitting areas RE and the plurality of optical members RL included in the first subpixel group RSPG may also be disposed side by side parallel to the X axis. With reference to FIG. 8 and FIG. 9, in the first subpixel group RSPG, the third optical member RL3 is shifted relative to RE3 (or the corresponding center lines CL) in the second direction parallel to the Y axis, the second optical member RL2 is not shifted relative to RE2 in a Y axis direction, and the first optical member RL1 is shifted in relative to RE1 (or the corresponding center lines CL) the first direction parallel to the Y axis, and these optical members may be sequentially disposed parallel to the X axis.

The plurality of subpixels included in the second subpixel group GSPG may be disposed side by side in the second direction parallel to the Y axis. Therefore, the plurality of optical members GL and the plurality of light-emitting areas GE of the second subpixel group GSPG may be disposed side by side in the second direction parallel to the Yaxis.

In addition, the plurality of second subpixel groups GSPG may each be disposed to interface with, in a direction parallel to the Y axis, each of the plurality of subpixels included in the first subpixel group RL1.

In this case, the plurality of optical members GL may be differently disposed in the plurality of second subpixel groups GSPG that respectively interface with the plurality of optical members RL of the first subpixel group RSPG.

Referring to FIG.9, in one pixel PX, the first optical member GL1, the second optical member GL2, and the third optical member GL3, which are shifted in different directions or are not shifted, represent each of the three "shift states" relative to the light-emitting areas GE and may be disposed in the same row in the plurality of second subpixel groups GSPG. FIG. 9 shows that, for both GSPG and BSPG subpixel group sets, each of the three "shift states" can be represented in each row and in each column of each 3 x 3 array disposed in the X-Y plane, where the two 3 x 3 arrays are integrated into a 3 x 6 array of alternately disposed GSPG and BSPG subpixel groups. The present disclosure is not limited by the described embodiments, and skilled practitioners will recognize that various other subpixel group configurations are possible and within the scope of the present disclosure.

According to embodiments, the viewing angle in the upward/downward direction may be restricted, thereby inhibiting an image from being visually recognized by being reflected by a structure positioned above the display device.

According to embodiments, it is possible to reduce, for a degraded device versus a non-degraded device, a luminance difference between a degraded light-emitting area and a non-degraded light-emitting area where that difference varies with viewing angle.

According to embodiments, it is possible to provide an image with higher quality than has previously been possible at various viewing angles regardless of a degree of degradation.

Although certain embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

## Claims

1. A display device having a display that includes a plurality of pixels, each pixel comprising:
a substrate layer;
a plurality of subpixels, each subpixel being configured to emit red, green, or blue light when electrically stimulated,
wherein each subpixel comprises:
a light emitting element comprising a first electrode layer, a light emitting layer, and a second electrode layer, formed sequentially on the substrate layer;
a touch buffer layer formed on the second electrode layer;
a touch electrode formed on the touch buffer layer; and
an optical member, peripheral portions of the optical member being formed on the touch electrode; and
a bank layer comprising an opening corresponding to each subpixel and defining a light emitting area for each light emitting element,
wherein the subpixels are grouped into subpixel groups, each subpixel group including three subpixels having a like color emission when electrically stimulated, the subpixels of each subpixel group being located immediately adjacent to another subpixel of that subpixel group,
wherein the subpixel groups are arrayed in two dimensions, X and Y, where subpixel groups corresponding to the three emitted colors, red, green, and blue, are substantially intermixed in their locations in the array, and where dimensions X, Y, and a third Z dimension are mutually perpendicular,
wherein a light emitting area for each subpixel, defined as an area traversed by emitted light after passing through the optical member and as projected onto the X-Y plane, is larger than the light emitting area for the corresponding light emitting element but substantially smaller than a projection of a shape of the optical member onto the X-Y plane,
wherein, for each subpixel group, a first subpixel has a subpixel light emitting area centrally aligned with the optical member along the Z axis, where a geometric center of the light emitting area coincides with a geometric center of a projection along the Z axis of the shape of the optical member onto the X-Y plane, a second subpixel has a subpixel light emitting area shifted in a first direction along the Y axis in comparison to the first subpixel, and a third subpixel has a subpixel light emitting area shifted in a second, opposite to the first, direction along the Y axis in comparison to the first subpixel, and
wherein, for each subpixel, the light emitting area is fully included within the projection along the Z axis of the shape of the optical member onto the X-Y plane.

2. The display device of claim 1, further comprising one or more additional touch electrodes formed on the touch buffer layer.

3. The display device of claim 2, wherein the plurality of touch electrodes are positioned on peripheral parts of the touch buffer layer and interface with peripheral portions of the optical member.

4. The display device of any preceding claim, wherein each pixel comprises a first subpixel group configured to emit red light, a second subpixel group configured to emit green light, and a third subpixel group configured to emit blue light.

5. The display device of claim 4, wherein each subpixel light emitting area is substantially rectangular in shape, the projection of the shape of each optical member onto the X-Y plane is substantially rectangular in shape, the subpixels are arrayed with long dimensions adjacent in each subpixel group, and subpixel groups are arrayed with short dimensions of the subpixels adjacent to short dimensions of a next subpixel group, and
wherein a three subpixel by three subpixel two dimensional array of subpixel light emitting areas is formed for each pixel in the X-Y plane.

6. The display device of claim 5, wherein for each pixel, for each subpixel row having a red emitting subpixel, a green emitting subpixel, and a blue emitting subpixel, each of the three subpixels has the same shift of subpixel light emitting area along the Y axis in comparison with the subpixel that is centrally aligned with the optical member along the Z axis; or
wherein for each pixel, for each subpixel row having a red emitting subpixel, a green emitting subpixel, and a blue emitting subpixel, each of the three subpixels has a different shift of subpixel light emitting area along the Y axis in comparison with the subpixel that is centrally aligned with the optical member along the Z axis.

7. The display device of any one of claims 4 to 6, wherein each pixel includes one first subpixel group, three second subpixel groups, and three third subpixel groups,
wherein each subpixel light emitting area is substantially rectangular in shape,
wherein the projection of the shape of each optical member onto the X-Y plane is substantially rectangular in shape,
wherein the subpixels are arrayed with long dimensions adjacent in each second or third subpixel group and the subpixels are arrayed with short dimensions adjacent in the first subpixel group, and subpixel groups are arrayed with short dimensions of the subpixels adjacent to short dimensions of subpixels of a next subpixel group for interfaces of a second subpixel group with a third subpixel group, but subpixel groups have long dimensions of the subpixels adjacent to long dimensions of a next subpixel group for interfaces of the first subpixel group with a second subpixel group or a third subpixel group, and
wherein an array in which each pixel includes seven subpixel groups is formed in the X-Y plane.

8. The display device of claim 7, wherein the first subpixel group is configured to emit a red color, the second subpixel groups are configured to emit a green color, and the third subpixel groups are configured to emit a blue color.

9. The display device of claim 7 or claim 8, wherein the second subpixel groups and the third subpixel groups are arranged alternately along the long dimension of the first subpixel group in the X-Y plane,
wherein each row of six second or third subpixel groups arranged with short subpixel dimensions adjacent has the same shift of subpixel light emitting area along the Y axis in comparison with the subpixel that is centrally aligned with the optical member along the Z axis.

10. The display device of claim 9, wherein the first subpixel group is configured to emit a red color, the second subpixel groups are configured to emit a green color, and the third subpixel groups are configured to emit a blue color.

11. The display device of claim 7, wherein the second subpixel groups and the third subpixel groups are arranged alternately along the long dimension of the first subpixel group in the X-Y plane,
wherein each row of six second or third subpixel groups arranged with short dimensions adjacent shows in equal numbers a shift of subpixel light emitting area along the Y axis in comparison with the subpixel that is centrally aligned with the optical member along the Z axis that is null (no shift), in the first direction along the Y axis, and in the second direction along the Y axis.

12. The display device of claim 11, wherein the first subpixel group is configured to emit a red color, the second subpixel groups are configured to emit a green color, and the third subpixel groups are configured to emit a blue color.

13. The display device of any preceding claim, wherein a buffer film is formed on the substrate, a transistor layer is formed on the buffer film, an overcoating layer is formed on the transistor layer, and the first electrode layer is formed on the overcoating layer,
wherein the transistor layer comprises a gate insulation film formed on the buffer layer, a first interlayer insulation film formed on the gate insulation film, and a lower protective film formed on the first interlayer insulation film,
wherein, in a region of each subpixel, a transistor is formed in the transistor layer corresponding to each first electrode layer, each transistor comprising:
a semiconductor layer formed on the buffer film;
the gate insulation film formed on the semiconductor layer;
a gate electrode formed on the gate insulation film;
the first interlayer insulation film formed on the gate electrode;
a source electrode formed on the first interlayer insulation film and in electrical contact with the semiconductor layer;
a drain electrode formed on the first interlayer insulation film and in electrical contact with the semiconductor layer;
the lower protective film formed on the source electrode and the drain electrode; and
the overcoating layer formed on the lower protective film, and
wherein the first electrode layer is in electrical contact with either the source electrode or the drain electrode.

14. The display device of claim 13, wherein an encapsulation member is formed on the second electrode layer,
wherein the touch buffer layer is formed on the encapsulation member,
wherein one or more touch bridge electrodes are formed on peripheral regions of the touch buffer layer,
wherein a second insulation film is formed on the one or more touch bridge electrodes and on the touch buffer layer,
wherein one or more opaque black matrix layer areas are formed on peripheral portions of the second insulation film,
wherein a third interlayer insulation film is formed on the opaque black matrix layer and on the second insulation film,
wherein the one or more touch electrodes are formed on the third interlayer insulation film,
wherein the optical member is formed on the touch electrodes and on the third interlayer insulation film,
wherein an optical member protection film is formed on the touch electrodes and on the optical member,
wherein each touch electrode penetrates the third interlayer insulation film, the black matrix and the second insulation film to electrically contact a touch bridge electrode, and wherein the encapsulation member comprises a first encapsulation layer, a second encapsulation layer, and a third encapsulation layer, which are sequentially formed on the second electrode layer.

15. The display device of any preceding claim, wherein a perceived dependence of a luminance on a viewing angle is reduced in comparison with a comparable device for which all subpixel light emitting areas are centrally aligned with the corresponding subpixel optical member along the Z axis; and/or
wherein the Y axis extends along a vertical direction of a display screen; and/or
wherein all optical members are arrayed in rows and columns in the X-Y plane, and wherein each optical member is separated from each neighboring optical member by the same distance; and/or
wherein a portion of the bank layer corresponding to a peripheral region of each opening in the bank layer is formed on the first electrode layer of each subpixel, thereby preventing light emission from each said peripheral region of each opening in the bank layer; and/or
wherein the substrate layer, the light emitting layer, the second electrode layer, and the touch buffer layer are continuous across the entire display.
